(19) Europäisches Patentamt
European Patent Office
Office européen des brevets

(11) **EP 2 544 369 B1**

(12) **EUROPEAN PATENT SPECIFICATION**

(45) Date of publication and mention
of the grant of the patent:
**04.06.2014 Bulletin 2014/23**

(51) Int Cl.:
***H03H 7/25*** *(2006.01)* ***H01P 1/22*** *(2006.01)*

(21) Application number: **11360028.2**

(22) Date of filing: **04.07.2011**

(54) **Attenuator**

Dämpfungsglied

Atténuateur

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**09.01.2013 Bulletin 2013/02**

(73) Proprietor: **Alcatel Lucent
75007 Paris (FR)**

(72) Inventor: **Bulja, Senad
Ashtown, 15 Dublin (IE)**

(74) Representative: **Sarup, David Alexander
Alcatel-Lucent Telecom Ltd
Intellectual Property Business Group
Christchurch Way
Greenwich
London SE10 0AG (GB)**

(56) References cited:
**JP-A- 11 191 740      JP-A- 2005 318 293
US-A- 4 216 445       US-A- 4 460 879
US-A- 5 109 204       US-A- 5 392 011
US-A- 5 811 961       US-A1- 2009 231 058**

• LUCYSZYN S ET AL: "MMIC tunable active notch
filter", ELECTRONICS LETTERS, IEE, vol. 32, no.
11, 23 May 1996 (1996-05-23), pages 980-981,
XP006005169,

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

FIELD OF THE INVENTION

The present invention relates to an attenuator and a method.

BACKGROUND

Attenuators are known. In particular, RF attenuators are widely used in radar systems, point to point radio, smart antennas and in radio frequency (RF) signal cancellation. The choice of antenna for a particular application is influenced by many factors, such as the required dynamic range, insertion losses, power consumption, linearity and power handling capabilities. For lower power handling capabilities and lower costs, PIN diodes or field effect transistors (FETs) are usually used to achieve such attenuation. These devices are well suited for use as attenuators because the resistance of a PIN diode is direct current (DC) current controlled and so the higher the current through the PIN diode, the lower the resistance. The resistance of FET based attenuators is DC voltage controlled, typically in the order of a few volts, which depends on the breakdown voltage of the gate-source junction.

Although these arrangements provide for functional attenuators, the performance of such attenuators may be less than optimal in some circumstances.

US 5,392,011 discloses a tuneable filter including a first resonator and a second resonator. The bandwidth of the tuneable filter is maintained constant by providing purely inductive coupling between the first and second resonators.

US 4,460,879 discloses a variable tuning device where an input signal is supplied to a first port of a non-reversible circuit and those frequency components of the input signal applied to a second ports of the non-reversible circuit which differ from the resonance frequency of a resonance element connected to the second port are absorbed by a resistive terminating element connected to the second port.

US 2009/0231058 discloses a bandpass filter having a small phase change in a passband and a steep frequency characteristic.

US 5,811,961 discloses an amplitude and phase adjustment circuit for modifying or reducing the phase and amplitude of a signal.

LUCYSZYN S ET AL: "MMIC tunable active notch filter", ELECTRONICS LETTERS, IEE, vol. 32, no. 11,23 May 1996, pages 980-981, discloses a novel microwave notch filter which has a single stage reflection topology.

JP 2005318293 discloses a stop filter where two terminals of a circulator are made to be input/output terminals. A variable resonant circuit, having a variable reactance element including a resistance component is connected to the remaining one terminal via an impedance transformer.

Accordingly, it is desired to provide an improved attenuator.

SUMMARY

According to a first aspect, there is provided an attenuator as claimed in claim 1.

The first aspect recognises that there are problems with existing PIN and FET based attenuators. The first is the power consumption; as the variation of resistance of a PIN diode is controlled by DC current, PIN based attenuators dissipate power. Second is noise performance; the fact that the modulation of resistance of PIN diodes is controlled by current gives rise to the deterioration in the noise performance of PIN diode based attenuators. In particular, the noise commonly referred to as "shot noise" is increased in PIN based devices. Such shot noise is increased due to the mobility of charge carriers (electrons and holes) which constitute the current through the PIN diode. The third is the control voltages of the PIN and FET based attenuators are relatively small (up to around 2 volts) and this has an adverse effect on the intermodulation performance of such devices. Although a PIN based reflection type attenuator (where PIN diodes are provided in the circuit of the reflective loads) attempt to alleviate some of these problems, their performance is still less than optimal. The operation of reflective type attenuators is relatively simple; depending on the bias voltage of the PIN diodes, the circuit of the reflective load (which consists of the PIN diodes) either absorbs or reflects the incident power on them. Radio frequency (RF) power absorption occurs when the impedance of the PIN diodes has a real part and is at its highest when the PIN diode's impedance is purely real and equal to the terminating impedance of the attached 3dB coupler (usually 50 Ohms). When this occurs, the RF signal is infinitely attenuated. RF power reflection occurs when the PIN diode's impedance has no real part. When this occurs, there is no signal attenuation. For a reflection-type attenuator to be variable, the impedance of the PIN diode must therefore be such that its impedance is resistive and varies between 0 and 50 Ohms. However, in practice this is never achieved; the impedance of the PIN diode is never completely real, even when the PIN diode is in the die form. Also, like any other semiconductor device, a PIN diode exhibits parasitic effects (such as resistance and capacitance) due to packaging. All these effects influence the impedance dependency of the PIN diode on the bias voltage in a way that complete absorption and reflection of the RF signal is impossible. Typically, the parameter of importance for a PIN diode based reflective type attenuator is the dynamic range (the difference between the maximum and minimum attenuation between two bias voltage states). Although attenuators can be designed to operate at bias voltages from 0 to 12 volts, high voltage biasing is enabled by the addition of two biasing resistors. Even though the addition of the resistors is beneficial from the point of protecting the PIN diodes from unintentional voltage increases beyond its rated range, this creates two further drawbacks. The first is that the addition of the resistors increases power consumption of the attenuator. The second is that the PIN diodes experience the same sensitivity to the external biased voltage as they did without the resistors in the circuit. Also, apart from the improvement in the protection of the PIN diodes using the biasing resistors, such attenuators suffer from the usual problems generally attributed to pin based attenuators. In particular, in the frequency range between 1.805 to 1.99 GHz, the insertion loss at a bias voltage of 0 volts is 1.5 and the attenuation at a bias voltage of 12 volts is 23.

Accordingly, the first aspect recognises that the performance of the attenuator can be improved by replacing the power consuming PIN device with a device that consumes no or very little power. The first aspect recognises that if the replacement device can be controlled by a higher DC voltage than that typically used in PIN and FET attenuators, improved intermodulation performance can be achieved. Such an approach enables the versatile structure of the reflection type attenuator to be retained whilst achieving performance improvements through changes to the circuit of the reflective load.

Accordingly, an attenuator is provided. The attenuator may has an input which receives an input signal which is to be attenuated. A 3dB coupler is provided which couples with the input and with an output which provides an attenuated input signal. At least one reflective load is coupled with the 3dB coupler to receive the input signal. The reflective load has a series arrangement of the varactor diode and an inductor in parallel with a series arrangement of a capacitor and a resistor. Such an approach accounts for parasitic resistances and enables complete attenuation of the RF signal to occur. This helps to increase the dynamic range of the attenuator.

Providing a reflective load having a varactor diode gives an arrangement of a variable reactance element that consumes very little power. When operating a varactor diode in, for example, an inverse regime, the bias voltages needed for correct operation are much higher than the bias voltages required by PIN diodes and FETs. This helps provide for improved intermodulation performance of a varactor based reflection type attenuator. The power consumption is determined by the leakage current of the varactor, which is in the order of nanoamps. This provides for a very low power consumption device. By way of comparison, a PIN diode consumes a current that is approximately $10^6$ times greater than the current consumption of a varactor. Furthermore, the switching speed of varactors is greater than the switching speed of pin diodes due to the fact that varactors are voltage controlled rather than the current control required for PIN diodes.

In one embodiment, on inductance of the inductor comprises $\dfrac{1}{\omega^2 C_{vh}}$, where $\omega$ is a carrier frequency of the input signal and Cvh is a high bias capacitance of the varactor diode.

In one embodiment, a capacitance of the capacitor and a resistance of the resistor at a low bias of the varactor diode is set to present a real component of impedance to the 3dB coupler which matches a characteristic impedance of the coupling device and an imaginary component of impedance which is substantially zero.

In one embodiment, the attenuator comprises an impedance transformer coupling the 3dB coupler with the reflective load. This embodiment recognises that insertion loss is a strong function of the parasitic resistance of the varactor diode and that the optimisation of the capacitor and resistor in order to yield high attenuation at low bias voltages may have a detrimental effect on the insertion loss at high bias voltages (which may lead to an increase of the impedance at high bias). The addition of an impedance transformer improves the insertion loss performance of the attenuator while at the same time offering high attenuation at low bias voltages.

In one embodiment, a characteristic impedance of the impedance transformer comprises $\sqrt{Z_t \cdot Z'_{in(low\text{-}bias)}}$, where $Z_t$ is a characteristic impedance of the 3dB coupler and $Z'_{in(towbias)}$ is an impedance presented by the reflective load to the impedance transformer at a low bias of the varactor diode. This approach enables total attenuation of the RF signal at low bias voltages and control of the insertion loss at high bias voltages.

In one embodiment, the impedance transformer comprises a quarter wave microstrip line.

In one embodiment, the impedance transformer comprises a tapered quarter wave microstrip line.

In one embodiment, the impedance transformer comprises a quarter wave lumped equivalent circuit.

In one embodiment, the quarter wave lumped equivalent circuit comprises a lumped inductor and a pair of lumped capacitors, wherein an inductance of the lumped inductor comprises $\dfrac{Z_{ctr}}{\omega}$ and a capacitance of the pair of

lumped capacitors comprises $\dfrac{1}{Z_{ctr}\omega}$, where $Z_{ctr}$ is a characteristic impedance of the impedance transformer and $\omega$ is a carrier frequency of the input signal.

In one embodiment, the attenuator comprises at least apair of the reflective loads coupled with the 3dB coupler.

According to a second aspect, there is provided a method as claimed in claim 11.

In one embodiment, the method comprises the step of setting an inductance of the inductor to be $\dfrac{1}{\omega^2 C_{vh}}$, where $\omega$ is a carrier frequency of the input signal and Cvh is a high bias capacitance of the varactor diode.

In one embodiment, the method comprises the step of setting a capacitance of the capacitor and a resistance of the resistor at a low bias of the varactor diode to present a real component of impedance to the 3dB coupler which matches a characteristic impedance of the 3dB coupler and an imaginary component of impedance which is substantially zero.

In one embodiment, the method comprises the step of providing an impedance transformer coupling the 3dB coupler with the reflective load.

In one embodiment, the method comprises the step of setting a characteristic impedance of the impedance transformer to be $\sqrt{Z_t . Z'_{in(lowbias)}}$, where $Z_t$ is a characteristic impedance of the coupling device and $Z'_{in(lowbias)}$ is an impedance presented by the reflective load to the impedance transformer at a low bias of the varactor diode.

In one embodiment, the impedance transformer comprises a quarter wave microstrip line.

In one embodiment, the impedance transformer comprises a tapered quarter wave microstrip line.

In one embodiment, the impedance transformer comprises a quarter wave lumped equivalent circuit.

In one embodiment, the quarter wave lumped equivalent circuit comprises a lumped inductor and a pair of lumped capacitors, and the method comprises the step of setting an inductance of the lumped inductor to be $\dfrac{Z_{ctr}}{\omega}$ and a capacitance of the pair of lumped capacitors to be $\dfrac{1}{Z_{ctr}\omega}$, where $Z_{ctr}$ is a characteristic impedance of the impedance transformer and $\omega$ is a carrier frequency of the input signal.

In one embodiment, the method comprises the step of providing at least a pair of the reflective loads coupled with the 3dB coupler.

Further particular and preferred aspects are set out in the accompanying independent and dependent claims. Features of the dependent claims may be combined with features of the independent claims as appropriate.

Where an apparatus feature is described as being operable to provide a function, it will be appreciated that this includes an apparatus feature which provides that function or which is adapted or configured to provide that function.

BRIEF DESCRIPTION OF THE DRAWINGS

Embodiments of the present invention will now be described further, with reference to the accompanying drawings, in which:

Figure 1 illustrates an arrangement of a reflective load attenuator according to one embodiment;
Figure 2 illustrates an example reflective load using a varactor diode and ideal lumped elements;
Figure 3 illustrates a modified reflective load according to one embodiment;
Figure 4 shows a circuit implementation of the attenuator having the modified reflective load of Figure 3;
Figure 5 illustrates the measured impedance variation of this diode versus bias voltage at 2.5 gigahertz;
Figure 6 shows a reflective load according incorporating a quarter wave impedance transformer according to one embodiment;
Figure 7 shows a circuit implementation of the attenuator having the modified reactive load of Figure 6;
Figure 8 shows a circuit implementation of the attenuator having a tapered quarter wave transformer;
Figure 9 shows a circuit implementation of the attenuator having a lumped equivalent quarter wave transformer; and
Figure 10 shows the responses of the attenuators as function of applied bias voltage at 2.5 gigahertz.

DESCRIPTION OF THE EMBODIMENTS

Overview

Before describing embodiments in any detail, an overview will first be provided. Embodiments seek to replace the power-consuming PIN device of existing attenuators with a device that consumes no or very little power. The replacement device should also be controllable by a higher direct current (DC) voltage than that typically used in PIN devices or field effect transistors in order to provide for improved intermodulation performance. In doing so, the versatile structure of a reflection-type attenuator can be retained; that is, embodiments feature a 3dB coupler, with enhancements being made to the circuit of the reflective load.

A variable reactance element that consumes very little power is a varactor diode. Also, when operated in an inverse regime, the bias voltages needed for correct operation of the varactor diode are much higher than the bias voltages required by PIN or FET devices. This helps to provide for better intermodulation performance of a varactor-based attenuator. The power consumption is limited by the leakage current of the varactor, which is in the order of nanoamps. This provides a very low power consumption device. By comparison, a PIN diode consumes a current that is approximately $10^6$ greater than the current consumption of a varactor device. Furthermore, the switching speed of a varactor diode is greater than the switching speed of PIN devices due to the varactor devices being voltage controlled, whereas PIN devices are current controlled.

To ensure correct operation, the reflective load of the attenuator needs to ensure a variation of its reflection coefficient so that the incident radio frequency (RF) power is either completely absorbed or reflected, as described in Equation 1:

$$\Gamma = \frac{Z_{in} - Z_c}{Z_{in} + Z_c} \qquad (1)$$

As can be seen, all RF power is absorbed by the reflective load when $Z_{IN} = Zc$, where $Z_{IN}$ is the impedance of the reflective load and $Z_C$ is the characteristic impedance of an interconnecting line of the 3dB coupler. Likewise, all RF power is reflected when $Z_{IN} = 0$ or $Z_{IN} = \infty$.

Reflective Load Attenuator

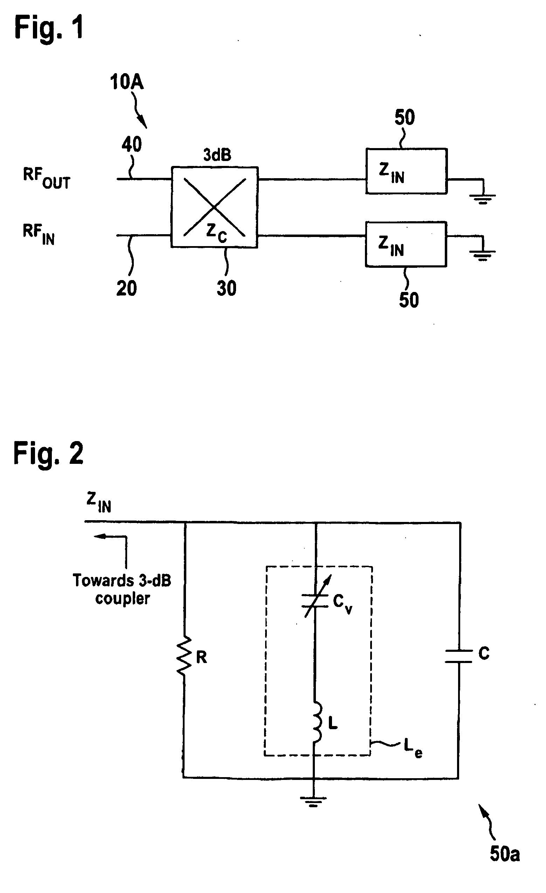

Figure 1 illustrates an arrangement of a reflective load attenuator 10A according to one embodiment. A signal $RF_{IN}$ is received at an input 20 and provided to a 3dB coupler 30. The attenuated signal $RF_{OUT}$ is provided at an output 40. A pair of reflective loads 50 are coupled with the 3dB coupler 30.

Ideal Lumped Element Reflective Load

Figure 2 illustrates an example reflective load using a varactor diode and ideal lumped elements. The reflective load 50a consists of four elements: a resistor R; a varactor Cv; an inductor L; and a capacitor C. This arrangement provides a simple reflective load using a varactor diode and assumes no parasitic resistances (which are considered and compensated for in arrangements described below).

The impedance of $Z_{IN}$ of the reflective load 50a consists of a real part and a reactive part. The real part is represented by the resistor R, while the reactive part contains the series connection of the varactor diode Cv and the inductor L shunted by the capacitor C.

At low bias voltages (and therefore high varactor capacitance), the reactance of the series connection of the varactor diode and the inductor is positive and can be represented by an equivalent inductor $L_e$ in accordance with Equation 2:

$$L_e = L - \frac{1}{\omega^2 C_{v\,max}} \qquad (2)$$

where $C_{vmax}$ represents the capacitance of the varactor diode at a low bias voltage and $\omega$ is the angular frequency of operation. If the parallel connection of the equivalent inductor $L_e$ and the capacitor C is made to resonate by satisfying Equation 3:

$$C = \frac{1}{\omega^2 L_e} \qquad (3)$$

then the reactive part of the impedance $Z_{IN}$ of the reflective load 50a vanishes, in other words imag($Z_{IN(low\ bias)}$) = 0, leaving only the real part, real($Z_{IN(low\ bias)}$) = R. By choosing the value of the resistor R to be equal to the characteristic impedance Zc of the interconnecting lines of the 3dB coupler (usually 50 ohms), total dissipation of the RF signal occurs at the output of the attenuator. This is because all RF power will be absorbed by the resistor R.

In order for the attenuator to provide no attenuation, the impedance $Z_{IN}$ of the reflective load 50a needs to be such that all RF power is reflected back to the 3dB coupler 30. This is achieved at a high bias voltage by setting the impedance $Z_{IN}$ of the reflective load to be either a short or open circuit. Since an open circuit cannot be realised using the circuit of Figure 2, a short circuit occurs by providing a series resonance between the varactor diode Cv and the inductor L at the high bias voltage. By setting the inductance in accordance with Equation 4:

$$L = \frac{1}{\omega^2 C_{v\ min}} \qquad (4)$$

$Z_{IN}$ = 0 is achieved when the bias voltage is high.

Accordingly, Equations 2 to 4 indicate that all values of the lumped elements of the reflective load 50a are defined in relation to the varactor diode and the frequency of operation of the attenuator.

However, as mentioned above, this arrangement assumes that all the lumped elements of the reflective load 50a are ideal and contain no parasitic resistances. Although this arrangement may provide satisfactory performance for some applications, performance can be further improved by taking into account the fact that in practice all of these lumped elements contain parasitic resistances.

The presence of the parasitic resistances means that the series resonance indicated by Equation 4 does not necessarily result in $Z_{IN}$ = 0, but only in the reactive part of the series connection of L and $C_{vmin}$ being equal to 0. The parasitic resistance of the series resonant connection of L and $C_{vmin}$ now forms a parallel connection with the capacitor C and the resistor R and its equivalent resistance effectively defines signal loss. The value of the equivalent parasitic resistance of this parallel connection is smaller than the values of the individual parasitic resistances which results in a smaller RF signal loss than that expected from the individual parasitic resistances.

However, the situation is far worse for low bias voltages. At such low bias voltages, when Equations 2 and 3 are satisfied (and the parallel resonance between $L_e$ and the capacitor C is achieved), the reactive part of the impedance of this parallel connection is infinite, but the resistive part (due to the parasitic resistances) has a small, finite value. This resistive part is connected in parallel with the resistor R. This parallel connection of the resistive part with the resistor R results in a resistance that is much smaller than Zc which would be required for complete RF signal dissipation.

In order to alleviate some of these problems, a modified reflective load is provided, as will now be described.

Modified Reflective Load Using Varactor Diode and Lumped Elements

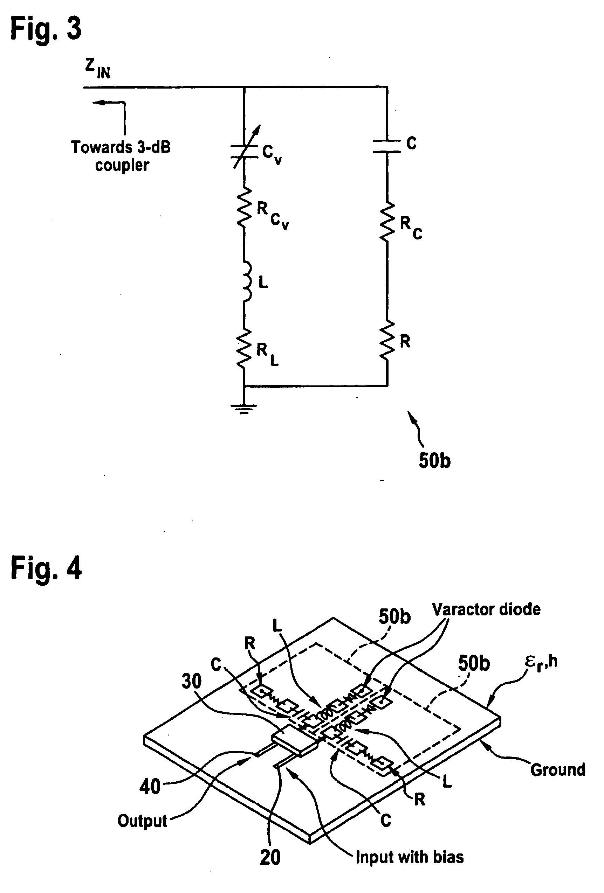

Figure 3 illustrates a modified reactive load 50b according to one embodiment. As can be seen, the parasitic resistances of each element are shown. $R_{CV}$, $R_L$ and $R_C$ ore the parasitic resistances of the varactor diode Cv, the inductor L and the shunt capacitor C, respectively. Also, the resistor R is now provided in series with the capacitor C.

At a high bias voltage, the impedance of the series connection of the varactor diode Cv and the inductor L is purely real and equal to $R_{CV} + R_L$, which in turn is shunted by the capacitor C, its parasitic resistance $R_C$ and resistor R. The impedance will have typically a small, finite value real ($Z_{IN(high\ bias)}$) ≈ 2 to 3 ohms and can be minimised by a suitable choice of varactor diode Cv. The impedance effectively defines the signal loss of the attenuator circuit.

At a low bias voltage, the capacitor C and resistor R are optimized so that the impedance is purely real and equal to the characteristic impedance of the interconnecting line of the 3dB coupler 30 (usually 50 ohms) so that dissipation of the RF signal occurs.

Hence, it can be seen that the values of the inductor L, the resistor R and the capacitor C can be determined as follows:

First, the value of the inductor L can be determined under high bias conditions to be in accordance with Equation 4A:

$$L = \frac{1}{\omega^2 C_{vh}} \qquad (4A)$$

The value of R and C can be determined at low bias from the following Equation 4B:

$$Z_{in} = f(R,C)$$
$$Z_{in} = f(R,C) = 50 + j0 \qquad (4B)$$
$$\left. \begin{array}{l} real(Z_{in}) = 50 \\ imag(Z_{in}) = 0 \end{array} \right)$$

Figure 4 shows a circuit implementation of the attenuator for operation at 2.5 gigahertz. This and the other circuit implementations are based on a varactor diode with a part number MHV-500 from Aeroflex Metellics (trade mark). This varactor diode allows a bias voltage variation between 0 and 18 volts, with a maximum reverse bias leakage current of 10 nanoamps. This provides a maximum power dissipation of only 0.2 microwatts.

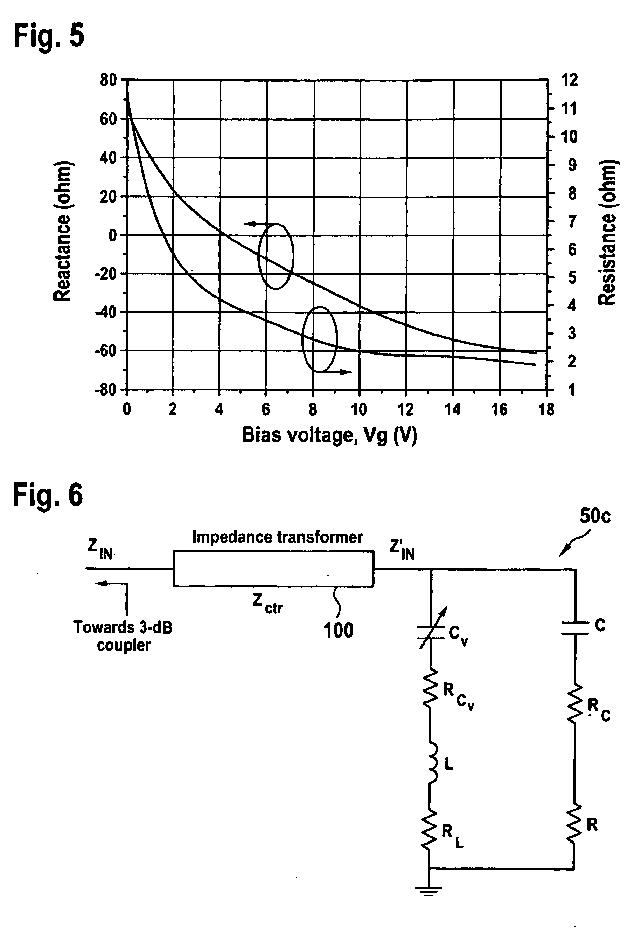

The measured impedance variation of this diode versus bias voltage at 2.5 gigahertz is shown in Figure 5. As can be seen, the MHV-500 diode exhibits an inductive behaviour at low bias voltages due to the terminal leads and packaging.

However, as the maximum (low bias voltage) and minimum (high bias voltage) capacitances of the varactor diode are readily available from the manufacturer's data sheet, this inductive behaviour can be extracted and used to partially realise the inductance L.

Also, it can be seen that the parasitic resistance of the MVH-500 diode is bias dependent and that is somewhat high, especially at low bias voltages.

The attenuators described are designed on a Roger Duroid RO 4350 (trade mark) substrate with $\varepsilon_r$ = 3.66 and h = 101 micrometres. The lumped elements needed for the circuit of the reflective loads were realising using .s2p files for each lumped element available from AVX. This is done so that the parasitic resistances are included in the simulations and that the responses of the attenuators are as realistic as possible.

Although the dynamic range of the arrangement shown in Figure 3 is increased compared to that shown in Figure 2, there are certain drawbacks with this circuit also. First, the insertion loss is a strong function of the parasitic resistance $R_{CV}$ of the varactor diode Cv. Second, the optimization of the capacitor C and resistor R in order to yield high attenuation at low bias voltages may have a detrimental effect on the insertion loss at high bias voltages (this may lead to an increase of $Z_{IN(high\ bias)}$. These shortfalls are addressed with a further optimization, which will now be described in more detail below.

Reflective Load with Impedance Transformer

Figure 6 shows a reflective load 50c according to one embodiment. This is similar to the arrangement shown in Figure 3. However, an impedance transformer 100 is added to the reflective load 50c. The addition of the impedance transformer 100 improves the insertion loss performance of the attenuator whilst offering high attenuation at low bias voltages.

As mentioned above, RF power is fully reflected provided that $Z_{IN}$ = 0 or $Z_{IN} \rightarrow \infty$; that is, when the reflection coefficient, Γ, of the reflective load is high. By requiring that $Z_{IN(high\ bias)}$ is very low (ideally, 0 ohms), a lower limit is quickly reached and this is dictated by the parasitic resistances of the lumped components, namely $R_{CV}$, $R_L$, $R_C$, as well as the resistor R.

However, requiring $Z_{IN(high\ bias)} \rightarrow \infty$, also imposes certain limits as to how a perfect open-circuit can be achieved, but the conditions are generally more relaxed than the ones needed for a perfect short.

One way of achieving a very high value of $Z_{IN(high\ bias)}$ is by the use of the impedance transformer 100. However, an assessment should be made of the insertion loss which results and whether the open-circuit offers superior performance over its short-circuit counterpart.

Table 1 presents the values of $Z_{IN}$ (high bias) at which 1 dB insertion loss is achieved:

| Insertion loss (dB) | $Z_{in(high\ bias)}$ (Ω) (near short) | $Z_{in(high\ bias)}$ (Ω) (near open) |
|---|---|---|
| 1 | <2.88 | >870 |

7

It is evident from this table that in order for the near open-circuit to offer the same performance as the near short-circuit (with a resistance of 2.88 ohms), it must experience a resistance of over 870 ohms. However, whereas the near short-circuit resistance of $Z_{IN(high\ bias)}$ is dictated by the lumped elements, the resistance at high bias voltages can be controlled by the choice of the characteristic impedance of the impedance transformer 100. This, in turn, allows for the control of insertion losses. However, care needs to be taken to ensure that $Z_{IN(low\ bias)}$ is still purely real and equal to the terminating impedance Zt of the 3dB coupler 30.

These requirements are met in the following way: in order for the circuit of Figure 6 to offer lower insertion losses than that of Figure 3, $Z'_{IN(low\ bias)}$ of Figure 6 is chosen such that it is purely real and greater than the terminating impedance $Z_t$ of the 3dB coupler 30. This is ensured by the optimization of the capacitor C and resistor R. The characteristic impedance $Z_{ctr}$ of the impedance transformer 100 is then found from the condition of total RF signal dissipation as described in Equation 5:

$$Z_{ctr} = \sqrt{Z_t \cdot Z'_{in(lowbias)}} \quad (5)$$

This leads to Equations 6 and 7:

$$Z_{in(lowbias)} = \frac{Z_{ctr}^2}{Z'_{in(lowbias)}} \quad (6)$$

$$Z_{in(highbias)} = \frac{Z_{ctr}^2}{Z'_{in(highbias)}} \quad (7)$$

Once Equation 5 is satisfied, Equation 6 states that total power dissipation of the RF signal at low bias voltages is achieved. Also achieved is the control of the insertion loss at high bias voltages, indicated by Equation 7 by the correct choice of the characteristic impedance $Z_{ctr}$. Moreover, the only constraint in the reduction of the insertion losses lies with the feasibility of the high impedance transformer.

However, as will become apparent from the description below, using an impedance transformer with a moderate characteristic impedance $Z_{ctr} \approx 70$ ohms, the insertion losses are halved, compared to the insertion loss achieved without a transformer.

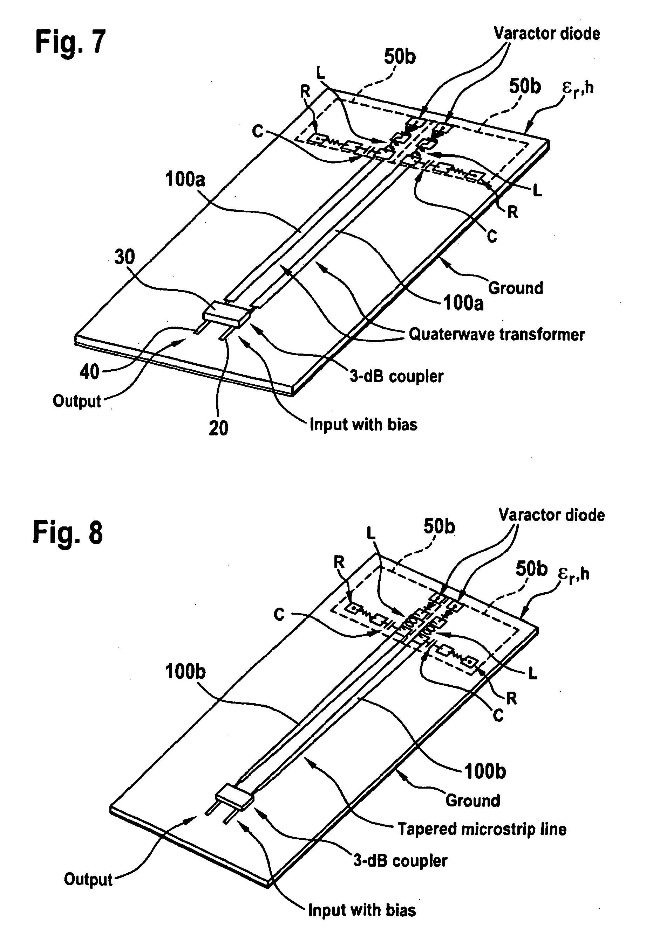

Figure 7 illustrates an attenuator device incorporating quarter wave impedance transformers 100a.

Figure 8 illustrates an attenuator with a tapered quarter wave transformer 100b.

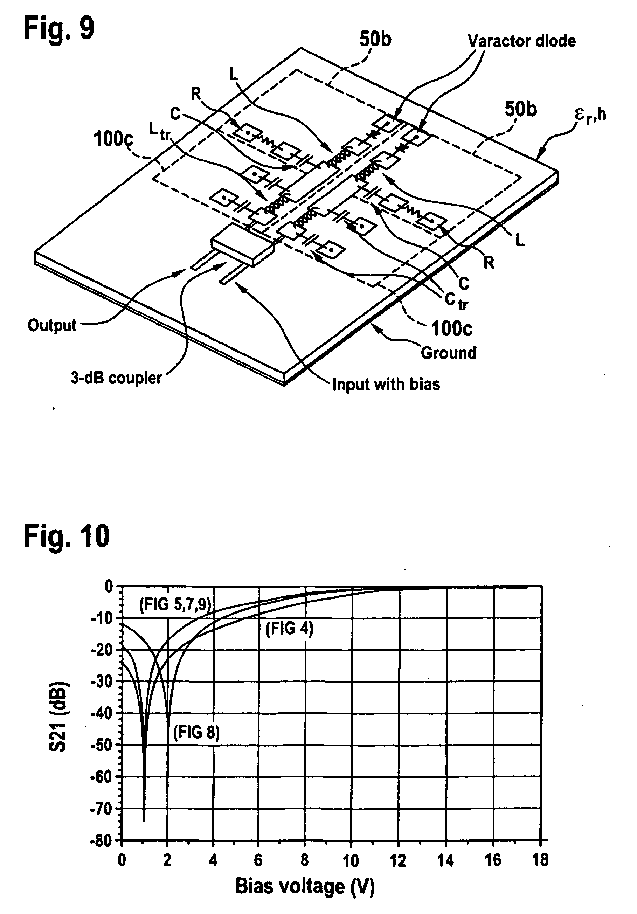

Figure 9 illustrates an attenuator device utilising a lumped equivalent quarter wave transformer 100c.

The role of each lumped element has already been explained, with the exception of $C_{tr}$ and $L_{tr}$. If the characteristic impedance of the quarter wave transformer of Figure 9 is denoted as $Z_{ctr}$ then the values of $C_{tr}$ and $L_{tr}$ are given by Equation 8:

$$C_{tr} = \frac{1}{Z_{ctr}\omega} \quad \text{and} \quad L_{tr} = \frac{Z_{ctr}}{\omega} \quad (8)$$

The responses of the attenuators are presented in Figure 10 as function of applied bias voltage $V_G$ at 2.5 gigahertz. The characteristic impedance of the quarter wave transformers 100a to 100c is 70 ohms. As Figure 10 illustrates, the responses of the attenuators with different implementations of the impedance transformer are similar. They all offer high attenuation at low bias voltages (typically around 60dB) and no attenuation at high bias voltages (typically around 0.5dB). For the arrangements of the distributed and lumped implementations of the impedance transformer shown in Figures 7 and 9 respectively, the high attenuation region peaks at about 1 volt, while for the tapered implementation of Figure 8, high losses occur at a bias voltage of about 2 volts. The low loss region for all three attenuators is at a high bias voltage of around 17 volts.

The performance of the attenuator of Figure 4 is also presented in Figure 10. As with the attenuators of Figures 7 to 9, this offers high attenuation at low bias. However, its insertion loss at high bias voltages is about 1dB, which is about two times greater than the arrangements utilising an impedance transformer. This provides an indication that the insertion loss can be controlled by a suitable choice of impedance transformer.

In terms of implementation, the lumped equivalent impedance transformer of Figure 9 is the most attractive implementation due to its small size when compared with the other implementations. However, due to the rather small percentage bandwidth of the lumped element impedance transformer, the implementations with distributed impedance transformers provide for increased bandwidth.

Also, if higher losses can be tolerated, the arrangement of Figure 4 would provide a broadband and more compact solution than that of Figure 9. However, this is at the expense of greater insertion losses. The attenuator with a tapered microstrip line shown in Figure 8 provides the broadest bandwidth at the expense of having the largest size of all three attenuators. Also, due to the resonant nature of the reflective loads, the bandwidth of the varactor-based reflective attenuators is limited to about 100-200 MHz, depending on the required high attenuation bandwidth. This compares favourably with cost-effective PIN-based reflective attenuators.

The power capability of the varactor-based reflective attenuator is effectively dominated by the choice of the varactor diode, as the 3dB coupler and the lumped elements are generally capable of withstanding higher powers than the varactor diode itself. For the varactor diode, the maximum power handling capability is influenced by its reverse breakdown voltage and the amount of generated intermodulation distortion. By ensuring that the reverse breakdown voltage is never reached, the maximum power handling capability of the varactor diode is purely dictated by its intermodulation distortion. The intermodulation distortion of a varactor diode is a direct consequence of its capacitance dependence on the applied voltage, and, in general, the greater the variations in the capacitance versus the applied voltage, the greater the amount of intermodulation distortion. Viewed in this way, the intermodulation distortion is inherently the characteristic of the junction capacitance variation of the particular varactor diode and it can be minimised by the correct varactor diode choice. The junction capacitance of the varactor diode can be written as Equation 9:

$$C(V) = \frac{K}{(\phi + V)^n} \qquad (9)$$

where K is a capacitance constant, $\Phi$ is the built in potential of the diode, V is the applied variable composite voltage (bias + RF signal), C(V) is the junction capacitance and n is a grading coefficient of the varactor diode. Depending on the grading coefficient n, three types of junction profiles can be identified: implanted junction for n = 0.3; uniformly doped junction for n = 0.5; and abrupt to hyper-abrupt junction $0.5 \le n \le 1.5$.

From Equation 9, it can be inferred that abrupt to hyper-abrupt junctions yield the highest values of capacitance variation versus the applied voltage. However, this is at the expense of worsening the varactor diode's intermodulation performance. A compromise solution by using a uniformly doped junction can achieve a practical trade-off between the general intermodulation and large capacitance variation. Furthermore, due to the fact that the operating voltages of the varactor are greater than that of a PIN diode, the varactor-based reflective attenuator is inherently capable of handling greater powers than PIN-based reflective attenuators.

Accordingly, it can be seen that an arrangement which has the same or similar cost as PIN-based attenuators can be provided, but which consumes virtually no power. As well as improved power consumption, greater intermodulation and noise performance is provided, as well as higher switching speeds and higher power handling capability. Such varactor-based reflective attenuators may be utilised as low cost, flexible RF front ends for femto cells and wireless sensor network gateways, enabling smart adaptions of cell coverage.

A person of skill in the art would readily recognise that steps of various above-described methods can be performed by programmed computers. Herein, some embodiments are also intended to cover program storage devices, e.g., digital data storage media, which are machine or computer readable and encode machine-executable or computer-executable programs of instructions, wherein said instructions perform some or all of the steps of said above-described methods. The program storage devices may be, e.g., digital memories, magnetic storage media such as a magnetic disks and magnetic tapes, hard drives, or optically readable digital data storage media. The embodiments are also intended to cover computers programmed to perform said steps of the above-described methods.

The functions of the various elements shown in the Figures, including any functional blocks labelled as "processors" or "logic", may be provided through the use of dedicated hardware as well as hardware capable of executing software in association with appropriate software. When provided by a processor, the functions may be provided by a single dedicated processor, by a single shared processor, or by a plurality of individual processors, some of which may be shared. Moreover, explicit use of the term "processor" or "controller" or "logic" should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and nonvolatile storage. Other hardware, conventional and/or custom, may also be included. Similarly, any switches shown in the Figures are conceptual only. Their function may be carried out through the operation of program logic, through dedicated logic, through the interaction of program control and dedicated logic, or even manually, the particular technique being selectable by the implementer as more specifically understood from the context.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

The description and drawings merely illustrate the principles of the invention. It will thus be appreciated that those skilled in the art will be able to devise various arrangements that, although not explicitly described or shown herein, embody the principles of the invention and are included within its scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

**Claims**

1. An attenuator, comprising:

   an(20) input operable to receive an input signal ($RF_{in}$) to be attenuated;
   a 3dB coupler coupled with said input and with an output (40) providing an attenuated input signal($RF_{out}$); and
   at least one reflective load (50B; 50c) coupled with said 3dB coupler to receive said input signal, said reflective load comprising a series arrangement of a varactor diode ($C_v$) and an inductor (L) in parallel with a series arrangement of a capacitor (C) and a resistor (R).

2. The attenuator of claim 1, wherein an inductance of said inductor comprises $\dfrac{1}{\omega^2 C_{vh}}$, where $\omega$ is a carrier frequency of said input signal and $C_{vh}$ is a high bias capacitance of said varactor diode.

3. The attenuator of claim 1 or 2, wherein a capacitance of said capacitor and a resistance of said resistor at a low bias of said varactor diode is set to present a real component of impedance to said 3dB coupler which matches a characteristic impedance of said 3dB coupler and an imaginary component of impedance which is substantially zero.

4. The attenuator of any preceding claim, comprising an impedance transformer (100) coupling said 3dB coupler with said reflective load.

5. The attenuator of claim 4, wherein a characteristic impedance of said impedance transformer comprises $\sqrt{Z_t . Z'_{in(lowbias)}}$, where $Z_t$ is a characteristic impedance of said 3dB coupler and $Z'_{in(lowbias)}$ is an impedance presented by said reflective load to said impedance transformer at a low bias of said varactor diode.

6. The attenuator of claim 4 or 5, wherein said impedance transformer comprises a quarter wave microstrip line.

7. The attenuator of any one of claims 4 to 6, wherein said impedance transformer comprises a tapered quarter wave microstrip line.

8. The attenuator of claim 4 or 5, wherein said impedance transformer comprises a quarter wave lumped equivalent circuit.

9. The attenuator of claim 8, wherein said quarter wave lumped equivalent circuit comprises a lumped inductor and a pair of lumped capacitors, wherein an inductance of said lumped inductor comprises $\dfrac{Z_{ctr}}{\omega}$ and a capacitance of said pair of lumped capacitors comprises $\dfrac{1}{Z_{ctr}\omega}$, where $Z_{ctr}$ is a characteristic impedance of said impedance transformer and $\omega$ is a carrier frequency of said input signal.

10. The attenuator of any preceding claim, wherein the attenuator comprises at least a pair of the reflective loads coupled with the 3dB coupler.

11. A method, comprising the steps of:

provide an(20) input operable to receive an input signal (RFin) to be attenuated;
providing a 3dB coupler coupled with said input and with an output (40) providing an attenuated input signal (RFout); and
providing at least one reflective load (50B; 50c) coupled with said 3dB coupler to receive said input signal, said reflective load comprising a series arrangement of a varactor diode ($C_v$) and an inductor (L) in parallel with a series arrangement of a capacitor (C) and a resistor (R).

**Patentansprüche**

1. Dämpfungsglied, umfassend:

Einen Eingang (20), betreibbar für den Empfang eines zu dämpfenden Eingangssignals ($RF_{in}$);
einen 3dB-Koppler, welcher mit dem besagten Eingang und mit einem Ausgang (40) gekoppelt ist, welcher ein gedämpftes Eingangssignal ($RF_{out}$) bereitstellt; und
mindestens eine reflektierende Last (50B, 50C), welche mit dem besagten 3dB-Koppler gekoppelt ist, um das besagte Eingangssignal zu empfangen, wobei die besagte reflektierende Last eine Serienanordnung einer Varaktordiode ($C_v$) und einen mit einer Serienanordnung eines Kondensators (C) und eines Widerstands (R) parallelgeschalteten Induktor (L) umfasst.

2. Dämpfungsglied nach Anspruch 1, wobei eine Induktivität des besagten Induktors $\dfrac{1}{\omega^2 C_{vh}}$ umfasst, wobei $\omega$ eine Trägerfrequenz des besagten Eingangssignals ist und $C_{vh}$ eine Kapazität mit hoher Vorspannung der besagten Varaktordiode ist.

3. Dämpfungsglied nach Anspruch 1 oder 2, wobei eine Kapazität des besagten Kondensators und ein Widerstandswert des besagten Widerstands bei niedriger Vorspannung der besagten Varaktordiode derart eingestellt wird, dass sie dem besagten 3dB-Koppler eine reale Komponente der Impedanz, welche mit einer charakteristischen Impedanz des besagten 3dB-Kopplers übereinstimmt, und eine imaginäre Komponente der Impedanz, welche im Wesentlichen Null beträgt, präsentiert.

4. Dämpfungsglied nach einem beliebigen der vorstehenden Ansprüche, umfassend einen Impedanzwandler (100), welcher den besagten 3dB-Koppler mit der besagten reflektierenden Last koppelt.

5. Dämpfungsglied nach Anspruch 4, wobei eine charakteristische Impedanz des besagten Impedanzwandlers $\sqrt{Z_t \cdot Z'_{in(lowbias)}}$ umfasst, wobei $Z_t$ eine charakteristische Impedanz des besagten 3dB-Kopplers ist und $Z'_{in(lowbias)}$ eine dem besagten Impedanzwandler durch die besagte reflektierende Last präsentierte Impedanz bei einer niedrigen Vorspannung der besagten Varaktordiode ist.

6. Dämpfungsglied nach Anspruch 4 oder 5, wobei der besagte Impedanzwandler eine Viertelwellen-Mikrostreifenleitung umfasst.

7. Dämpfungsglied nach einem beliebigen der Ansprüche 4 bis 6, wobei der besagte Impedanzwandler eine sich verjüngende Viertelwellen-Mikrostreifenleitung umfasst.

8. Dämpfungsglied nach Anspruch 4 oder 5, wobei der besagte Impedanzwandler eine konzentrierte Viertelwellen-Ersatzschaltung umfasst.

9. Dämpfungsglied nach Anspruch 8, wobei die besagte konzentrierte Viertelwellen-Ersatzschaltung einen konzentrierten Induktor und ein Paar von konzentrierten Kondensatoren umfasst, wobei eine Induktivität des besagten konzentrierten Induktors $\dfrac{Z_{ctr}}{\omega}$ umfasst und eine Kapazität des besagten Paars von konzentrierten Kondensatoren $\dfrac{1}{Z_{ctr}\omega}$ umfasst, wobei $Z_{ctr}$ eine charakteristische Impedanz des besagten Impedanzwandlers ist und $\omega$ eine Trägerfrequenz des besagten Eingangssignals ist.

10. Dämpfungsglied nach einem beliebigen der vorstehenden Ansprüche, wobei das Dämpfungsglied zumindest ein mit dem 3dB-Koppler gekoppeltes Paar der reflektierenden Lasten umfasst.

11. Verfahren, die folgenden Schritte umfassend:

Bereitstellen (20) eines Eingangs, welcher betreibbar ist, um ein zu dämpfendes Eingangssignal (RF$_{in}$) zu empfangen;
Bereitstellen eines 3dB-Kopplers, der mit dem besagten Eingang und mit einem Ausgang (40) gekoppelt ist, welcher ein gedämpftes Eingangssignal (RF$_{out}$) bereitstellt; und
Bereitstellen mindestens einer reflektierenden Last (50B, 50C), welche mit dem besagten 3dB-Koppler gekoppelt ist, um das besagte Eingangssignal zu empfangen, wobei die besagte reflektierende Last eine Serienanordnung einer Varaktordiode (C$_v$) und einen mit einer Serienanordnung eines Kondensators (C) und eines Widerstands (R) parallelgeschalteten Induktor (L) umfasst.

## Revendications

1. Atténuateur, comprenant :

une (20) entrée permettant de recevoir un signal d'entrée (RF$_{in}$) devant être atténué ;
un coupleur 3dB couplé à ladite entrée et à une sortie (40) fournissant un signal d'entrée atténué (RF$_{out}$), et
au moins une charge réflective (50B ; 50C) couplée audit coupleur 3dB pour recevoir ledit signal d'entrée, ladite charge réflective comprenant un agencement en série d'une diode varactor (C$_v$) et d'un inducteur (L) en parallèle avec un agencement en série d'un condensateur (C) et d'une résistance (R).

2. Atténuateur selon la revendication 1, dans lequel une inductance dudit inducteur comprend

$$\frac{1}{\omega^2 C_{vh}}$$

, où $\omega$ est une fréquence porteuse dudit signal d'entrée et $C_{vh}$ est une capacité de polarisation élevée de ladite diode varactor.

3. Atténuateur selon la revendication 1 ou 2, dans lequel une capacité dudit condensateur et une résistance de ladite résistance à une faible polarisation de ladite diode varactor sont définies pour présenter une composante réelle de l'impédance pour ledit coupleur 3dB qui correspond à une impédance caractéristique dudit coupleur 3dB et une composante imaginaire de l'impédance qui est sensiblement égale à zéro.

4. Atténuateur selon l'une quelconque des revendications précédentes, comprenant un transformateur d'impédance (100) couplant ledit coupleur 3dB à ladite charge réflective.

5. Atténuateur selon la revendication 4, dans lequel une impédance caractéristique dudit transformateur d'impédance comprend

$$\sqrt{Z_t . Z'_{in(lowbias)}}$$

où $Z_t$ est une impédance caractéristique dudit coupleur 3dB et $Z'_{in(lowbias)}$ est une impédance présentée par ladite charge réflective pour ledit transformateur d'impédance à une faible polarisation de ladite diode varactor.

6. Atténuateur selon la revendication 4 ou 5, dans lequel ledit transformateur d'impédance comprend une ligne microruban quart d'onde.

7. Atténuateur selon l'une quelconque des revendications 4 à 6, dans lequel ledit transformateur d'impédance comprend une ligne microruban quart d'onde conique.

8. Atténuateur selon la revendication 4 ou 5, dans lequel ledit transformateur d'impédance comprend un circuit équivalent à constantes localisées quart d'onde.

9. Atténuateur selon la revendication 8, dans lequel ledit circuit équivalent à constantes localisées quart d'onde comprend un inducteur regroupé et une paire de condensateurs regroupés, dans lequel une inductance dudit inducteur regroupé comprend

$$\frac{Z_{ctr}}{\omega}$$

et une capacité de ladite paire de condensateurs regroupés comprend

$$\frac{1}{Z_{ctr}\omega}$$

, où $Z_{ctr}$ est une impédance caractéristique dudit transformateur d'impédance et $\omega$ est une fréquence porteuse dudit signal d'entrée.

10. Atténuateur selon l'une quelconque des revendications précédentes, l'atténuateur comprenant au moins une paire des charges réflectives couplées au coupleur 3dB.

11. Procédé comprenant les étapes suivantes :

fournir une entrée (20) permettant de recevoir un signal d'entrée (RFin) devant être atténué ;
fournir un coupleur 3dB couplé à ladite entrée et à une sortie (40) fournissant un signal d'entrée atténué (RFout) ; et
fournir au moins une charge réflective (50B ; 50C) couplée audit coupleur 3dB pour recevoir ledit signal d'entrée, ladite charge réflective comprenant un agencement en série d'une diode varactor (Cv) et d'un inducteur (L) en parallèle avec un agencement en série d'un condensateur (C) et d'une résistance (R).

## Fig. 1

10A

40

3dB

50

RF$_{OUT}$

Z$_{IN}$

RF$_{IN}$

Z$_C$

Z$_{IN}$

20

30

50

## Fig. 2

Z$_{IN}$

Towards 3-dB
coupler

R

C$_v$

C

L

L$_e$

50a

# Fig. 3

$Z_{IN}$

Towards 3-dB
coupler

$C_v$

$R_{C_v}$

L

$R_L$

C

$R_C$

R

50b

# Fig. 4

Varactor diode

50b

50b

$\varepsilon_r, h$

R

L

C

30

40

Output

20

Input with bias

L

R

C

Ground

# Fig. 5

# Fig. 6

## Fig. 7

Varactor diode

50b

50b  $\varepsilon_r, h$

L

R

C

100a

30

40

Output

20

Input with bias

100a

Ground

Quaterwave transformer

3-dB coupler

L

R

C

## Fig. 8

Varactor diode

50b

50b  $\varepsilon_r, h$

L

R

C

100b

Output

Input with bias

3-dB coupler

Tapered microstrip line

Ground

100b

L

R

C

## Fig. 9

## Fig. 10

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5392011 A
- US 4460879 A
- US 20090231058 A

- US 5811961 A
- JP 2005318293 B

**Non-patent literature cited in the description**

- **LUCYSZYN S et al.** MMIC tunable active notch filter. *ELECTRONICS LETTERS, IEE,* 23 May 1996, vol. 32 (11), 980-981